# EUROPEAN PATENT APPLICATION

(11) **EP 4 715 518 A1**
(43) Date of publication of application: **25.03.2026**
(21) Application number: 24832248.9
(22) Date of filing: 14.05.2024
(51) Int. Cl.: G06F 1/16, G05G 5/05

(54) **ELECTRONIC DEVICE INCLUDING FOOT**

(30) Priority: 30.06.2023 KR 20230085240; 01.08.2023 KR 20230100510
(71) Applicant: Samsung Electronics Co., Ltd., Suwon-si, Gyeonggi-do 16677 (KR)
(72) Inventor: LIN, Huiyuan, Suwon-si Gyeonggi-do 16677 (KR); KIM, Iksang, Suwon-si Gyeonggi-do 16677 (KR)
(74) Representative: Gulde & Partner
(86) International application number: PCT/KR2024/006572
(87) International publication number: WO 2025/005464

(57) **Abstract**

An electronic device according to an embodiment may include: a first housing; a second housing; a main shaft; an elastic body connected to the first housing; and a foot connected to the elastic body, wherein the foot is pressed by the second housing and moved relative to the first housing while the second housing is being transitioned from a closed state to an unfolded state, and is restored to the initial position by the restoring force of the elastic body while the second housing is being transitioned from the unfolded state to the closed state.

## Description

### Technical Field

Various embodiments of the present disclosure relate to an electronic device, for example, an electronic device including a foot.

### Background Art

As hardware components of electronic devices, for example, laptop computers (personal computers), become miniaturized and the efficiency of batteries improves, technologies for reducing the thickness of electronic devices are being developed. When the thickness is reduced, rigidity may be weakened. For example, even when an electronic device is configured with a metallic material, a thin structure in a plate shape may have weak rigidity. For example, in a laptop computer, a second housing that is relatively thinner than a first housing requires a more rigid structure.

When the second housing of the laptop computer has an approximately "L" shape, the second housing may have sufficient rigidity, while the laptop computer as a whole may have a thin structure. However, for the "L"-shaped second housing to rotate and open, it is necessary to space a bottom surface of the laptop computer apart from the ground by a specific distance. The laptop computer may include a foot for preventing the second housing from directly contacting the ground. Even when the second housing is in a closed state, if the foot has an excessively protruding shape, an overall thickness of the laptop computer may increase. Meanwhile, when the second housing is in an open state, if the foot does not have a sufficiently protruding shape, there is a possibility that the second housing may directly contact the ground.

Accordingly, there is a demand for a structure in which the foot maintains a state in close contact with the first housing while the second housing is in a closed state, and the foot maintains a state sufficiently protruding from the first housing while the second housing is in an open state.

### DISCLOSURE OF THE INVENTION

According to an embodiment, an electronic device includes a first housing 210, a second housing 220 rotatably connected to the first housing and configured to switch states between a closed state and an open state, a main shaft 230 rotatably connecting the first housing and the second housing, an elastic body 240 connected to the first housing, and a foot 250 connected to the elastic body, the foot 250 being pressed by the second housing and moved relative to the first housing while the second housing is switched from the closed state to the open state, and restored to an initial position by a restoring force of the elastic body while the second housing is switched from the open state to the closed state.

According to an embodiment, an electronic device includes a first housing 210, a second housing 220 rotatably connected to the first housing and configured to switch states between a closed state and an open state, a main shaft 230 rotatably connecting the first housing and the second housing, a torsion spring 240 connected to the first housing, a foot 250 connected to the torsion spring, the foot 250 being pressed by the second housing and moved relative to the first housing while the second housing is switched from the closed state to the open state, and restored to an initial position by a restoring force of the torsion spring while the second housing is switched from the open state to the closed state, and a second hinge unit 260 including a first hinge frame connected to the first housing and supporting one end of the torsion spring and a second hinge frame connected to the foot, supporting the other end of the torsion spring, and rotatably connected to the first hinge frame, and when the second housing 220 is in the closed state, the torsion spring 240 may be provided in an extended state, and the torsion spring 240 may apply a restoring force to the foot to bring the foot into close contact with the second housing 220.

According to an embodiment, an electronic device includes a first housing 310, a second housing 320 rotatably connected to the first housing and configured to switch states between a closed state and an open state, a main shaft 330 rotatably connecting the first housing and the second housing, a plate spring 340 connected to the first housing, and a foot 350 connected to the plate spring, the foot 350 being pressed by the second housing and moved relative to the first housing while the second housing is switched from the closed state to the open state, and restored to an initial position by a restoring force of the plate spring while the second housing is switched from the open state to the closed state, and when the second housing 320 is in the closed state, the plate spring 340 may be provided in an extended state, and the plate spring 340 may apply a restoring force to the foot to bring the foot into close contact with the second housing 320.

### BRIEF DESCRIPTION OF DRAWINGS

The foregoing and other aspects, features, and advantages of embodiments in the disclosure will become apparent from the following detailed description with reference to the accompanying drawings.
FIG. 1 is a block diagram of an electronic device in a network environment according to an embodiment.
FIG. 2 is a cross-sectional view illustrating a second housing of an electronic device in a closed state according to an embodiment.
FIG. 3 is a cross-sectional view illustrating a second housing of an electronic device in an open state according to an embodiment.
FIG. 4 is an exploded perspective view of an electronic device according to an embodiment.
FIG. 5 is an exploded perspective view of an electronic device according to an embodiment.
FIG. 6 is a perspective view illustrating an elastic body, a foot, and a second hinge unit according to an embodiment.
FIG. 7 is a bottom view of an electronic device with a foot omitted according to an embodiment.
FIG. 8 is a cross-sectional view illustrating a second housing of an electronic device in a closed state according to an embodiment.
FIG. 9 is a cross-sectional view illustrating a second housing of an electronic device in an approximately 90-degree open state according to an embodiment.
FIG. 10 is a cross-sectional view illustrating a second housing of an electronic device in an approximately 135-degree open state according to an embodiment.
FIG. 11 is an exploded cross-sectional view of a body cover, a foot, and an elastic body according to an embodiment.
FIG. 12 is a cross-sectional view of a body cover, a foot, and an elastic body according to an embodiment.

### BEST MODE FOR CARRYING OUT THE INVENTION

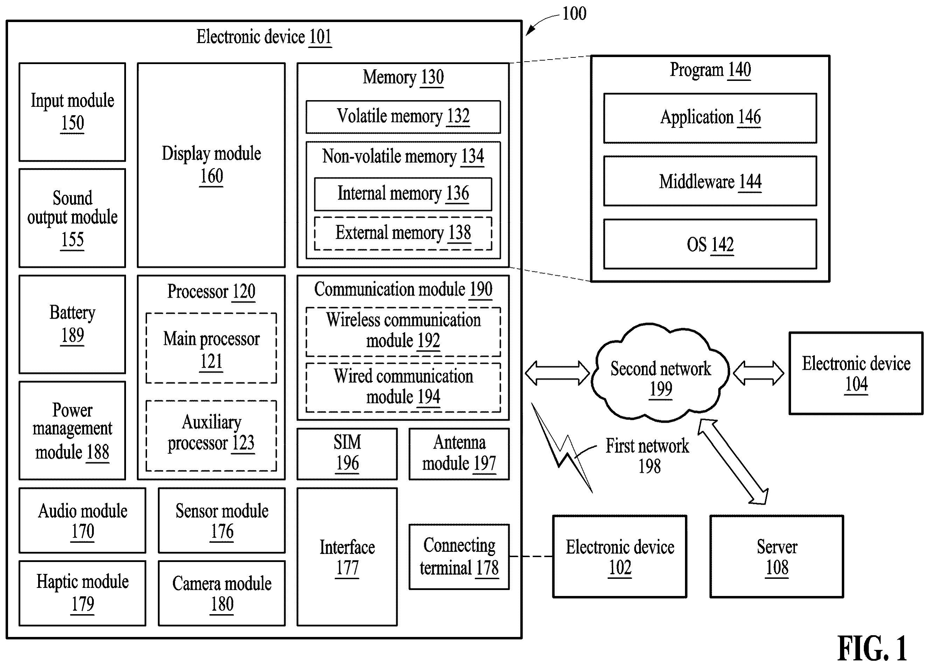

FIG. 1 is a block diagram of an electronic device in a network environment according to an embodiment.

Referring to FIG. 1, an electronic device 101 in a network environment 100 may communicate with an electronic device 102 via a first network 198 (e.g., a short-range wireless communication network) or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a second housing module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be integrated as a single component (e.g., the second housing module 160).

The processor 120 may execute, for example, software (e.g., a program 140) to control at least one other component (e.g., a hardware or software component) of the electronic device 101 connected to the processor 120 and may perform various data processing or computation. According to an embodiment, as at least a part of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one component (e.g., the second housing module 160, the sensor module 176, or the communication module 190) of the electronic device 101, instead of the main processor 121 while the main processor 121 is in an inactive (e.g., sleep) state, or together with the main processor 121 while the main processor 121 is in an active (e.g., application-executing) state. According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence model processing. An artificial intelligence model may be generated by machine learning. The machine learning may be performed by, for example, the electronic device 101, in which AI is performed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but examples are not limited thereto. The artificial intelligence model may additionally or alternatively include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored as software in the memory 130, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a recording. The receiver may be used to receive an incoming call. According to an embodiment, the receiver may be implemented separately from the speaker or as a part of the speaker.

The second housing module 160 may visually provide information to the outside (e.g., a user) of the electronic device 101. The second housing module 160 may include, for example, a second housing, a hologram device, or a projector and control circuitry to control a corresponding one of the second housing, the hologram device, and the projector. According to an embodiment, the second housing module 160 may include a touch sensor adapted to sense a touch, or a pressure sensor adapted to measure an intensity of a force incurred by the touch.

The audio module 170 may convert a sound into an electrical signal or vice versa. According to an embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electric signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently of the processor 120 (e.g., an AP) and that support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip) or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, for example, a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beamforming, or a large-scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to an embodiment, the antenna module 197 may form a mmWave antenna module. According to an embodiment, the mmWave antenna module may include a PCB, a RFIC disposed on a first surface (e.g., the bottom surface) of the PCB or adjacent to the first surface and capable of supporting a designated high-frequency band (e.g., the mmWave band), and a plurality of antennas (e.g., array antennas) disposed on a second surface (e.g., the top or a side surface) of the PCB, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to an embodiment, all or some of operations to be executed by the electronic device 101 may be executed at one or more external electronic devices (e.g., the external devices 102 and 104, and the server 108). For example, if the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or service, or an additional function or an additional service related to the request and may transfer a result of the performance to the electronic device 101. The electronic device 101 may provide the result, with or without further processing the result, as at least part of a response to the request. To that end, cloud computing, distributed computing, mobile edge computing (MEC), or client-server computing technology may be used, for example. The electronic device 101 may provide ultra-low-latency services using, e.g., distributed computing or mobile edge computing. In an embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to the embodiments disclosed herein may be one of various types of electronic devices. The electronic devices may include, for example, a portable communication device (e.g., a smart phone), a computer device, a portable multimedia device, a portable medical device, a camera, a wearable device, or a home appliance. According to an embodiment of the disclosure, the electronic devices are not limited to those described above.

It should be appreciated that embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second", or "first" or "second" may simply be used to distinguish the component from other components in question, and may refer to components in other aspects (e.g., importance or order) is not limited. It is to be understood that if a component (e.g., a first component) is referred to, with or without the term "operatively" or "communicatively," as "coupled with," "coupled to," "connected with," or "connected to" another component (e.g., a second component), the component may be coupled with the other component directly (e.g., wiredly), wirelessly, or via a third component.

As used in connection with embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium and execute it. This allows the machine to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to embodiments of the disclosure may be included and provided in a computer program product. The computer program product may be traded as a product between a seller and a buyer. The computer program product may be distributed in the form of a machine-readable storage medium (e.g., a compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities, and some of the multiple entities may be separately disposed in different components. According to embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

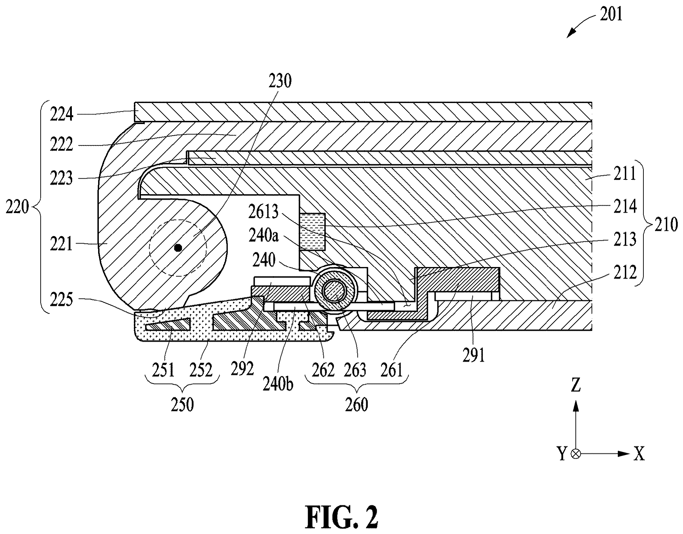

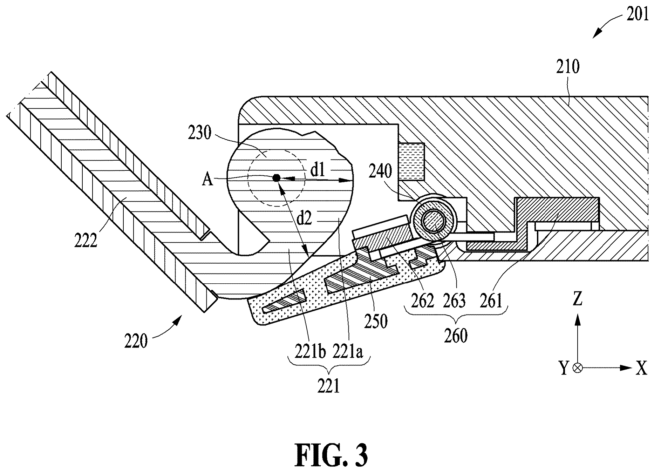

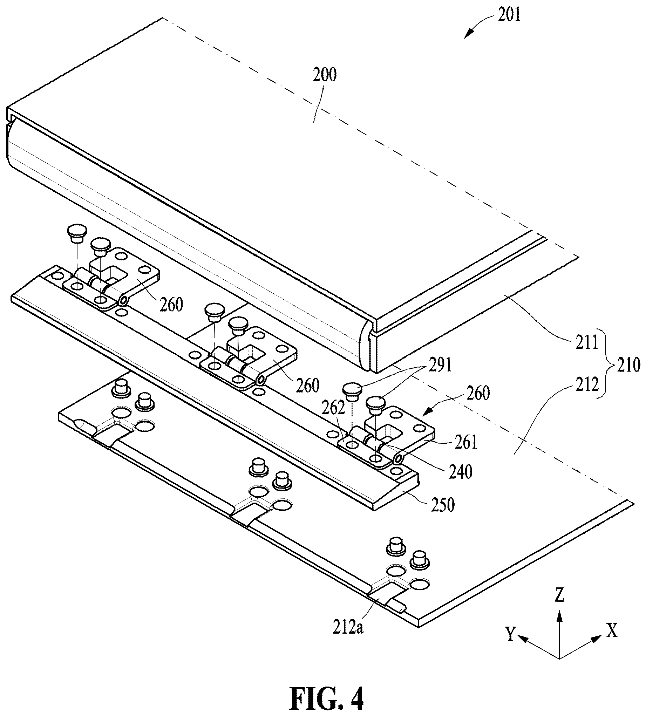

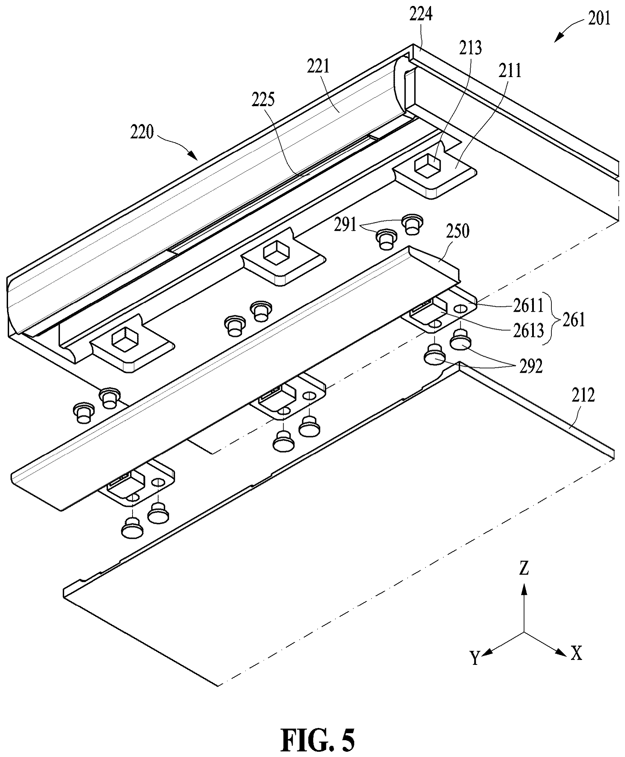

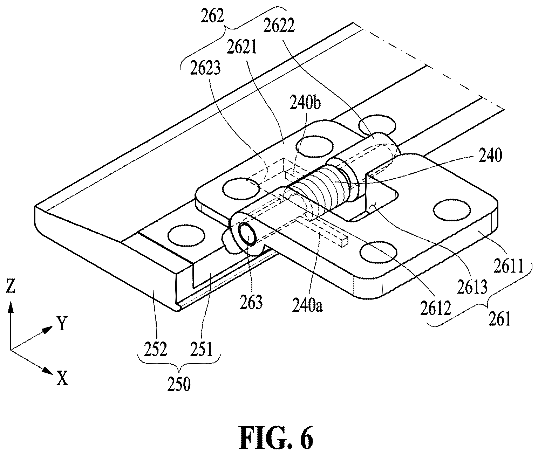

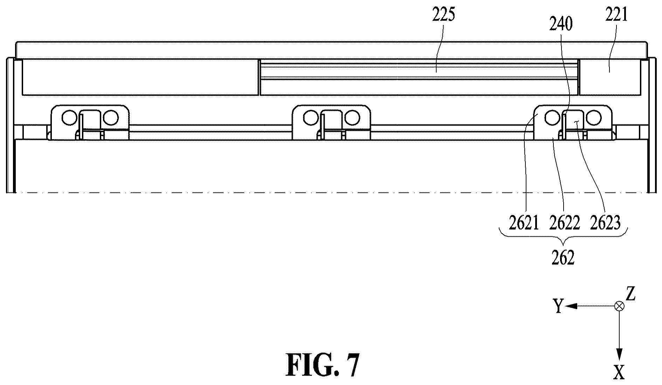

FIG. 2 is a cross-sectional view illustrating a second housing of an electronic device in a closed state according to an embodiment. FIG. 3 is a cross-sectional view illustrating a second housing of an electronic device in an open state according to an embodiment. FIG. 4 is an exploded perspective view of an electronic device according to an embodiment. FIG. 5 is an exploded perspective view of an electronic device according to an embodiment. FIG. 6 is a perspective view illustrating an elastic body, a foot, and a second hinge unit according to an embodiment. FIG. 7 is a bottom view of an electronic device with a foot omitted according to an embodiment.

Referring to FIGS. 2 to 7, an electronic device 201 (e.g., the electronic device 101 of FIG. 1) may be a laptop computer. The electronic device 201 may include a first housing 210, a second housing 220, a main shaft 230, an elastic body 240, a foot 250, a second hinge unit 260, and a plurality of screws 291 and 292.

The first housing 210 may accommodate various components of the electronic device 201. For example, the first housing 210 may accommodate at least one of a processor (e.g., the processor 120 of FIG. 1), an input module (e.g., the input module 150 of FIG. 1), a sound output module (e.g., the sound output module 155 of FIG. 1), a second housing module (e.g., the second housing module 160 of FIG. 1), an audio module (e.g., the audio module 170 of FIG. 1), a sensor module (e.g., the sensor module 176 of FIG. 1), an interface (e.g., the interface 177 of FIG. 1), a haptic module (e.g., the haptic module 179 of FIG. 1), a camera module (e.g., the camera module 180 of FIG. 1), a power management module (e.g., the power management module 188 of FIG. 1), a communication module (e.g., the communication module 190 of FIG. 1), a subscriber identification module (e.g., the subscriber identification module 196 of FIG. 1), or an antenna module (e.g., the antenna module 197 of FIG. 1). The first housing 210 may have a plate shape having a hollow inside. For example, the first housing 210 may be formed in an approximately cuboid shape. It should be noted that the shape of the first housing 210 is not limited thereto. The first housing 210 may include a body frame 211, a body cover 212, a positioning protrusion 213, and an air vent 214.

The body frame 211 may have a hollow (not shown) inside. The body frame 211 may support an interface (e.g., the interface 177 of FIG. 1) at a portion facing a +x direction. For example, the interface may be a keyboard. The body frame 211 may support an audio module (e.g., the audio module 170 of FIG. 1) at a portion facing the +x direction.

The body cover 212 may be disposed at a bottom surface of the body frame 211. The body cover 212 may protect the body frame 211. The body cover 212 may cover the body frame 2112. The body cover 212 may overlap the body frame 211 in a z-axis direction. The body cover 212 may have a plate shape.

The positioning protrusion 213 may protrude from the body frame 211. The positioning protrusion 213 may protrude from the body frame 211 in a -z direction. The positioning protrusion 213 may set a position of the second hinge unit 260. The positioning protrusion 213 may fix the second hinge unit 260 to prevent the second hinge unit 260 from being unintentionally shaken. The positioning protrusion 213 may press one end of the elastic body 240. A plurality of positioning protrusions 213 may be provided along a width direction of the body frame 211, that is, along a y-axis direction.

The air vent 214 may be formed in the body frame 211. The air vent 214 may discharge heat generated inside the body frame 211 to the outside. The air vent 214 may be covered by the second housing 220 when the second housing 220 is in a closed state and be exposed to the outside when the second housing 220 is in an open state. In such a structure, when the electronic device 201 is not in use, foreign substances may be prevented from entering the electronic device 201. In addition, during use of the electronic device 201, heat may be readily dissipated.

The second housing 220 may be rotatably connected to the first housing 210. The second housing 220 may switch a state between a closed state and an open state. For example, the second housing 220 may be switched from the closed state to the open state and be switched from the open state to the closed state.

Here, the closed state refers to a state in which the second housing 220 is closed on the first housing 210. In other words, the closed state refers to a state in which the second housing 220 and the first housing 210 overlap each other. In the closed state, an angle formed by the second housing 220 and the first housing 210 may be approximately 0 degrees. In the closed state, one surface of the second housing 220 may face one surface of the first housing 210. A user may bring the second housing 220 into the closed state when use of the electronic device 201 is terminated, or when the electronic device 201 is carried.

Here, the open state refers to a state in which the second housing 220 is unfolded from the first housing 210. In the open state, the second housing 220 may be spaced apart from the first housing 210. In the open state, an angle formed by the second housing 220 and the first housing 210 may be greater than 0 degrees. For example, in the open state, an angle formed by the second housing 220 and the first housing 210 may be 90 degrees or more. For a user to easily view a screen output from the second housing 220, an angle formed by the second housing 220 and the first housing 210 may be 90 degrees or more. While the second housing 220 is being opened, a portion of the second housing 220 may protrude in the -z direction. The foot 250, as described later, may move together with the second housing 220 and protect the second housing 220 so that the second housing 220 does not directly contact the ground.

The second housing 220 may include a second housing frame 222, a display unit 223, a second housing cover 224, and a damper 225. The second housing 220 may be connected to a first hinge unit. The first hinge unit may connect the first housing 210 and the second housing 220. The first hinge unit may rotatably connect the first housing 210 and the second housing 220. The first hinge unit may include a hinge body 221 and a main shaft 230.

The hinge body 221 may support the main shaft 230. For example, the hinge body 221 may rotatably support the main shaft 230. In this case, the main shaft 230 may be fixed to the first housing 210. For example, the hinge body 221 may be fixed to the main shaft 230. In this case, the main shaft 230 may be rotatably connected to the first housing 210. The hinge body 221 may include a round part 221a and a straight part 221b.

The round part 221a may be a portion having a constant distance d1 spaced apart from a central axis A of the main shaft 230. The straight part 221b may extend from the round part 221a. The straight part 221b may be a portion in which a distance d2 spaced apart from the central axis A of the main shaft 230 increases as the straight part 221b gets farther from the round part 221a. For example, while the second housing 220 is switched from a closed state to a state in which an angle formed by the second housing 220 and the first housing 210 becomes 90 degrees, the round part 221a may contact the foot 250. For example, while the second housing 220 is switched from the state in which the angle formed by the second housing 220 and the first housing 210 becomes 90 degrees to a state in which the angle becomes 135 degrees, the straight part 221b may contact the foot 250. The straight part 221b may prevent the foot 250 from excessively rotating.

The second housing frame 222 may extend from the hinge body 221. The second housing frame 222 may have a plate shape.

The display unit 223 may be disposed on the second housing frame 222. The display unit 223 may display an image to the outside.

The second housing cover 224 may protect the second housing frame 222.

The damper 225 may protrude from the hinge body 221. For example, the damper 225 may protrude toward the foot 250 based on a state in which the second housing 220 is in a closed state. The damper 225 may have a longitudinal direction corresponding to the y-axis direction. The damper 225 may assist in preventing the foot 250 from excessively contacting the second housing 220 when the second housing 220 is in the closed state.

The main shaft 230 may rotatably connect the first housing 210 and the second housing 220. The main shaft 230 may be fixed to one of the first housing 210 and the second housing 220.

The elastic body 240 may be connected to the first housing 210 and the foot 250. Here, the connection includes not only a direct connection but also an indirect connection. For example, the elastic body 240 may be directly connected to the first housing 210 or be connected to the first housing 210 via the second hinge unit 260. In an embodiment, although the elastic body 240 is illustrated and described as being connected to the first housing 210 and the foot 250 via the second hinge unit 260, embodiments are not limited thereto. For example, the elastic body 240 may be directly connected to the first housing 210 and/or the foot 250.

The elastic body 240 may be a torsion spring. The elastic body 240 may be connected to the second hinge unit 260. A portion of the elastic body 240 connected to the foot 250 may be pressed by the second housing 220 and may be moved relative to the first housing 210 while the second housing 220 is switched from a closed state to an open state. For example, the elastic body 240 may rotate about the first housing 210. The rotation axis of the elastic body 240 may be in a direction parallel to the y-axis. The elastic body 240 may apply a restoring force to the foot 250 while the second housing 220 is switched from the open state to a closed state. When the second housing 220 is in the closed state, the elastic body 240 may be provided in an extended state. When the second housing 220 is in the closed state, the elastic body 240 may apply a restoring force to the foot 250 to bring the foot 250 into close contact with the second housing 220.

The foot 250 may be pressed by the second housing 220 and may be moved away relative to the first housing 210 while the second housing 220 rotates in a first direction. The foot 250 may be moved closer relative to the first housing 210 while the second housing 220 rotates in a second direction opposite to the first direction.

The foot 250 may be connected to the elastic body 240. The foot 250 may be pressed by the second housing 220 and may be moved relative to the first housing 210 while the second housing 220 is switched from a closed state to an open state. For example, the elastic body 240 may rotate about the first housing 210. The foot 250 may be restored to an initial position by a restoring force of the elastic body 240 while the second housing 220 is switched from the open state to a closed state. The foot 250 may include a foot frame 251 supporting the elastic body 240 and a foot cover 252 covering the foot frame 251.

The foot frame 251 may include a rigid material. For example, the foot frame 251 may include aluminum. The foot frame 251 may support one end of the second hinge unit 260. The foot frame 251 may support the elastic body 240 disposed on the second hinge unit 260.

The foot cover 252 may include a flexible material. The foot cover 252 may include a material more flexible than a material of the foot frame 251. For example, the foot cover 252 may include rubber.

The foot 250 may move together with the second housing 220. When the second housing 220 is in a closed state, since the foot 250 is provided in close contact with the second housing 220, a bottom surface of the first housing 210 and a bottom surface of the foot 250 may be provided approximately in parallel in appearance. While the second housing 220 is switched to an open state, the foot 250 may move together with the second housing 220 and may protect the second housing 220 so that the second housing 220 does not contact the ground.

The second hinge unit 260 may include a first hinge frame 261 connected to the first housing 210, a second hinge frame 262 connected to the foot 250, and a hinge shaft 263 connecting the first hinge frame 261 and the second hinge frame 262.

The first hinge frame 261 may support one end 240a of the elastic body 240. The body cover 212 may be inserted into a first frame groove 2613. The first hinge frame 261 may be disposed between the body frame 211 and the body cover 212.

The first hinge frame 261 may include a first frame body 2611, a first frame arm 2612, and the first frame groove 2613. The first frame body 2611 may have a plate shape. The first frame body 2611 may be disposed between the body frame 211 and the body cover 212. The first frame arm 2612 may protrude from the first frame body 2611. For example, the first frame arm 2612 may protrude from the first frame body 2611 in a -x direction. The first frame arm 2612 may include a hole for accommodating the hinge shaft 263. The first frame groove 2613 may protrude from the first frame body 2611 in the -z direction. The first frame groove 2613 may accommodate at least a portion of the first housing 210. The first frame groove 2613 may accommodate the positioning protrusion 213. One surface of the first frame groove 2613 may support the elastic body 240. For example, a surface of the first frame groove 2613 facing a +z direction may support the elastic body 240. One end 240a of the elastic body 240 may be pressed by the first frame groove 2613 and the positioning protrusion 213.

The second hinge frame 262 may support the other end 240b of the elastic body 240. The second hinge frame 262 may be disposed at the foot 250. The second hinge frame 262 may be rotatably connected to the first hinge frame 261.

The second hinge frame 262 may include a second frame body 2621, a second frame arm 2622, and a second frame groove 2623. The second frame body 2621 may have a plate shape. The second frame body 2621 may be disposed at the foot frame 251. The second frame arm 2622 may protrude from the second frame body 2621. For example, the second frame arm 2622 may protrude from the second frame body 2621 in the +x direction. The second frame arm 2622 may overlap the first frame arm 2612 in the y-axis direction. The first frame arm 2612 and the second frame arm 2622 may be spaced apart from each other in the y-axis direction. The elastic body 240 may be provided between the first frame arm 2612 and the second frame arm 2622. The second frame arm 2622 may include a hole for accommodating the hinge shaft 263. The second frame groove 2623 may be recessed in the +z direction from one surface of the second frame body 2621. One surface of the second frame groove 2623 may support the elastic body 240.

The hinge shaft 263 may have one end inserted into the first hinge frame 261 and the other end inserted into the second hinge frame 262. The hinge shaft 263 may support the elastic body 240. A central portion of the elastic body 240 may be rotatably connected to the hinge shaft 263. The elastic body 240 may surround at least a portion of the hinge shaft 263.

A plurality of screws 291 and 292 may include a first screw 291 for fixing the first hinge frame 261 to the first housing 210 and a second screw 292 for fixing the second hinge frame 262 to the foot 250. The first screw 291 may connect the first hinge frame 261 and the body frame 211. The second screw 292 may connect the second hinge frame 262 and the foot frame 251.

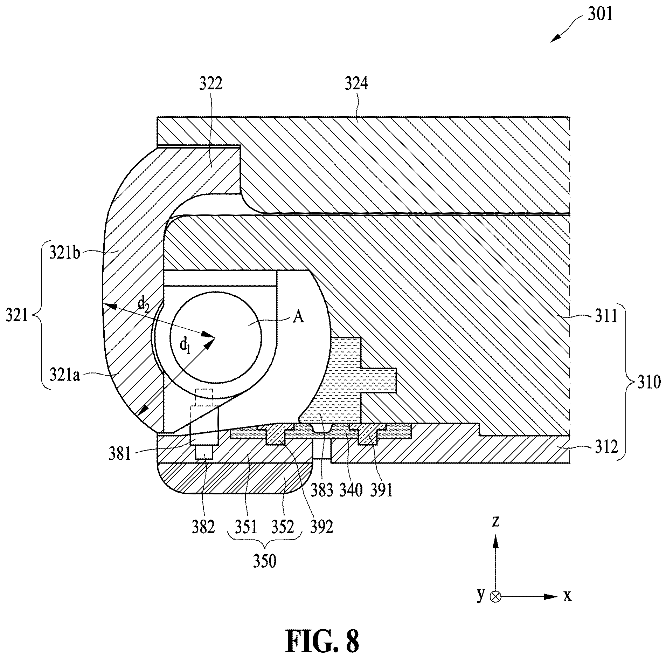

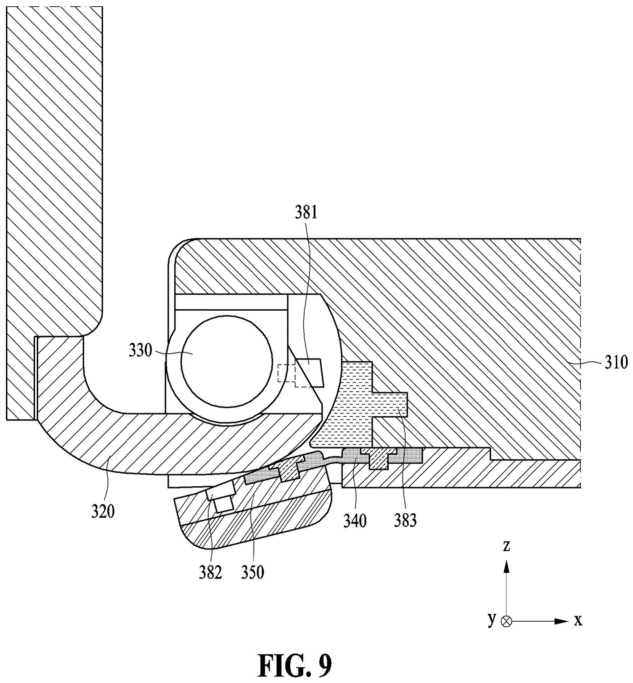

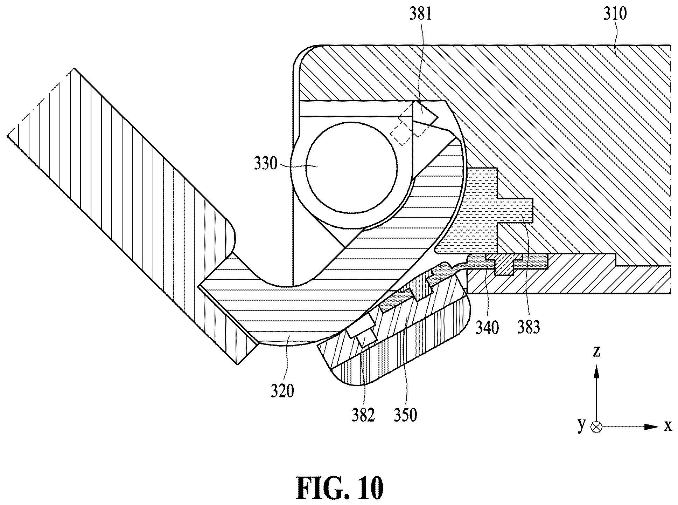

FIG. 8 is a cross-sectional view illustrating a second housing of an electronic device in a closed state according to an embodiment. FIG. 9 is a cross-sectional view illustrating a second housing of an electronic device in an approximately 90-degree open state according to an embodiment. FIG. 10 is a cross-sectional view illustrating a second housing of an electronic device in an approximately 135-degree open state according to an embodiment.

Referring to FIGS. 8 to 10, an electronic device 301 (e.g., the electronic device 101 of FIG. 1) may be a laptop computer. The electronic device 301 may include a first housing 310, a second housing 320, a main shaft 330, an elastic body 340, a foot 350, a plurality of dampers 381, 382, and 383, and a plurality of screws 291 and 292.

The first housing 310 may include a body frame 311 and a body cover 312.

The second housing 320 may be rotatably connected to the first housing 310. The second housing 320 may switch a state between a closed state and an open state. For example, the second housing 320 may be switched from the closed state to the open state and be switched from the open state to the closed state.

The second housing 320 may include a hinge body 321, a second housing frame 322, and a second housing cover 324. The hinge body 321 may be connected to the main shaft 330. For example, the hinge body 321 may be rotatably connected to the main shaft 330. In this case, the main shaft 330 may be fixed to the first housing 310. For example, the hinge body 321 may be fixed to the main shaft 330. In this case, the main shaft 330 may be rotatably connected to the first housing 310. The hinge body 321 may include a round part 321a and a straight part 321b.

The round part 321a may be a portion having a constant distance d1 spaced apart from a central axis A of the main shaft 330. The straight part 321b may extend from the round part 321a. The straight part 321b may be a portion in which a distance d2 spaced apart from the central axis A of the main shaft 330 increases as the straight part 321b gets farther from the round part 321a. For example, while the second housing 320 is switched from a closed state to a state in which an angle formed by the second housing 320 and the first housing 310 becomes 90 degrees, the round part 321a may contact the foot 350. For example, while the second housing 320 is switched from the state in which the angle formed by the second housing 320 and the first housing 310 becomes 90 degrees to a state in which the angle becomes 135 degrees, the straight part 321b may contact the foot 350. The straight part 321b may prevent the foot 350 from excessively rotating.

The main shaft 330 may rotatably connect the first housing 310 and the second housing 320. The main shaft 330 may be fixed to one of the first housing 310 and the second housing 320.

The elastic body 340 may be a plate spring. The elastic body 340 may have one end connected to the first housing 310 and the other end connected to the foot 350. A portion of the elastic body 340 connected to the foot 350 may be pressed by the second housing 320 and may be moved relative to the first housing 310 while the second housing 320 is switched from a closed state to an open state. For example, the elastic body 340 may rotate about the first housing 310. The rotation axis of the elastic body 340 may be in a direction parallel to the y-axis. The elastic body 340 may apply a restoring force to the foot 350 while the second housing 320 is switched from the open state to a closed state. When the second housing 320 is in the closed state, the elastic body 340 may be provided in an extended state. When the second housing 320 is in the closed state, the elastic body 340 may apply a restoring force to the foot 350 to bring the foot 350 into close contact with the second housing 320.

The foot 350 may include a foot frame 351 supporting the elastic body 340 and a foot cover 352 covering the foot frame 351.

The foot frame 351 may include a rigid material. For example, the foot frame 351 may include aluminum. The foot cover 352 may include a flexible material. The foot cover 352 may include a material more flexible than a material of the foot frame 351. For example, the foot cover 352 may include rubber.

A plurality of dampers 381, 382, and 383 may include a first damper 381 disposed at the second housing 320, a second damper 382 disposed at the foot 350, and a third damper 383 disposed at the first housing 310. The first damper 381 and the second damper 382 may face each other and may be provided in contact with each other when the second housing 320 is in a closed state. The third damper 383 may be provided in contact with the hinge body 321 when the second housing 320 is in an open state.

A plurality of screws 391 and 392 may include a first screw 391 for fixing one end of the elastic body 340 to the first housing 310 and a second screw 392 for fixing the other end of the elastic body 340 to the foot 350.

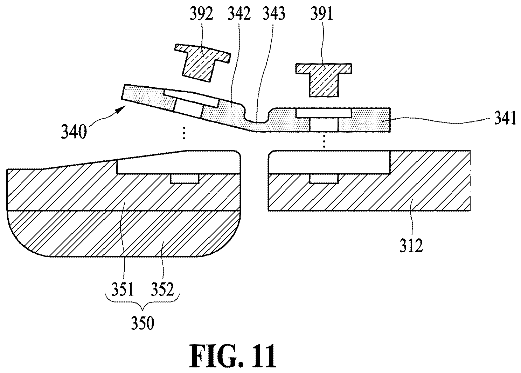

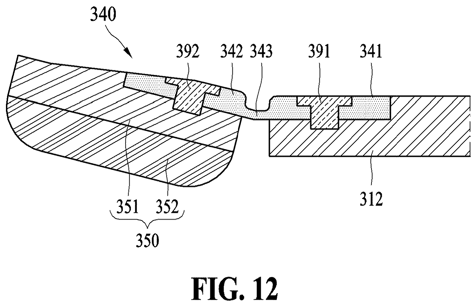

FIG. 11 is an exploded cross-sectional view of a body cover, a foot, and an elastic body according to an embodiment. FIG. 12 is a cross-sectional view of a body cover, a foot, and an elastic body according to an embodiment.

Referring to FIGS. 11 and 12, an elastic body 340 may include a first elastic body part 341 fixed to a body cover 312, a second elastic body part 342 fixed to a foot 350, and a connecting part 343 connecting the first elastic body part 341 and the second elastic body part 342. The first elastic body part 341 may be fixed to the body cover 312 by a first screw 391. The second elastic body part 342 may be fixed to the foot frame 351 by a second screw 392.

The elastic body 340 may have a bent shape while no external force is applied. When the second housing 320 is in a closed state, the elastic body 340 may be provided in a deformed state by the second housing 320. In such a structure, when the second housing 320 is in the closed state, the elastic body 340 may apply a restoring force to the foot 350 to bring the foot 350 into close contact with the second housing 320.

According to an embodiment, the electronic device may include a first housing 210, a second housing 220 rotatably connected to the first housing and configured to switch states between a closed state and an open state, a main shaft 230 rotatably connecting the first housing and the second housing, an elastic body 240 connected to the first housing, and a foot 250 connected to the elastic body, pressed by the second housing and moved relative to the first housing while the second housing is switched from the closed state to the open state, and restored to an initial position by a restoring force of the elastic body while the second housing is switched from the open state to the closed state.

In an embodiment, when the second housing 220 is in the closed state, the elastic body 240 may be provided in an extended state, and the elastic body 240 may apply a restoring force to the foot to bring the foot into close contact with the second housing 220.

In an embodiment, the foot 250 may include a foot frame 251 supporting the elastic body 240 and a foot cover 252 covering the foot frame 251 and having a material more flexible than a material of the foot frame 251.

In an embodiment, the electronic device may further include a second hinge unit 260 including a first hinge frame 261 connected to the first housing and supporting one end of the elastic body, and a second hinge frame 262 connected to the foot, supporting the other end of the elastic body, and rotatably connected to the first hinge frame 261.

In an embodiment, the second hinge unit 260 may further include a hinge shaft 263 having one end inserted into the first hinge frame, the other end inserted into the second hinge frame, and a central portion supporting the elastic body.

In an embodiment, the elastic body 240 may be a torsion spring.

In an embodiment, one end 240a of the elastic body 240 may be connected to the first hinge frame, and the other end 240b of the elastic body 240 may be connected to the second hinge frame.

In an embodiment, the one end 240a of the elastic body 240 may be provided in a state pressed by the first housing and the first hinge frame, and the other end 240b of the elastic body 240 may be provided in a state pressed by the second hinge frame and the foot.

In an embodiment, the first hinge frame 261 may include a first frame body 2611 connected to the foot frame and a first frame arm 2612 extending from the first frame body and supporting one end of the shaft, and the second hinge frame 262 may include a second frame body 2621 connected to the first housing and a second frame arm 2622 extending from the second frame body and supporting the other end of the shaft.

In an embodiment, the first housing may include a positioning protrusion 213 inserted into the inside of the first hinge frame.

In an embodiment, the elastic body 340 may be a plate spring.

In an embodiment, the electronic device may further include a first screw 391 fixing one end of the elastic body 340 to the first housing, and a second screw 392 fixing the other end of the elastic body 340 to the foot.

In an embodiment, the electronic device may further include a first damper 381 disposed on the second housing 320, and a second damper 382 disposed on the foot 350 and facing the first damper 381.

In an embodiment, the second housing 220 may include a hinge body 221 connected to the main shaft, a second housing frame 222 extending from the hinge body, and a damper 225 protruding from the hinge body in a direction away from the main shaft and pressing the foot.

In an embodiment, the hinge body 221 may include a round part 221a having a shape in which a distance spaced apart from a central axis of the main shaft is constant, and a straight part 221b having a shape in which a distance spaced apart from the central axis of the main shaft increases as the straight part 221b goes farther from the round part 221a.

According to an embodiment, the electronic device may include a first housing 210, a second housing 220 rotatably connected to the first housing and configured to switch states between a closed state and an open state, a main shaft 230 rotatably connecting the first housing and the second housing, a torsion spring 240 connected to the first housing, a foot 250 connected to the torsion spring, pressed by the second housing and moved relative to the first housing while the second housing is switched from the closed state to the open state, and restored to an initial position by a restoring force of the torsion spring while the second housing is switched from the open state to the closed state, and a second hinge unit 260 including a first hinge frame connected to the first housing and supporting one end of the torsion spring, and a second hinge frame connected to the foot, supporting the other end of the torsion spring, and rotatably connected to the first hinge frame, and when the second housing 220 is in the closed state, the torsion spring 240 may be in an extended state, and the torsion spring 240 may apply a restoring force to the foot to bring the foot into close contact with the second housing.

In an embodiment, the foot 250 may include a foot frame 251 supporting the torsion spring and a foot cover 252 covering the foot frame and having a material more flexible than a material of the foot frame.

In an embodiment, the second hinge unit 260 may further include a hinge shaft 263 having one end inserted into the first hinge frame, the other end inserted into the second hinge frame, and a central portion supporting the torsion spring.

In an embodiment, one end of the torsion spring may be provided in a state pressed by the first housing and the first hinge frame, and the other end of the torsion spring may be provided in a state pressed by the second hinge frame and the foot.

According to an embodiment, the electronic device may include a first housing 310, a second housing 320 rotatably connected to the first housing and configured to switch states between a closed state and an open state, a main shaft 330 rotatably connecting the first housing and the second housing, a plate spring 340 connected to the first housing, and a foot 350 connected to the plate spring, pressed by the second housing and moved relative to the first housing while the second housing is switched from the closed state to the open state, and restored to an initial position by a restoring force of the plate spring while the second housing is switched from the open state to the closed state, and when the second housing 320 is in the closed state, the plate spring may be in an extended state, and the plate spring may apply a restoring force to the foot to bring the foot into close contact with the second housing.

The effects of the electronic device according to embodiments are not limited to the above-mentioned effects, and other unmentioned effects can be clearly understood from the following description by one of ordinary skill in the art.

The embodiments of the present disclosure are intended to be illustrative and not restrictive. Various modifications may be made to the detailed description of the present disclosure including the accompanying scope of claims and equivalents. Any of the embodiment(s) described herein may be used in combination with any other embodiment(s) described herein.

## Claims

1. An electronic device comprising:
a first housing 210;
a second housing 220 accommodating a display unit 223;
a first hinge unit rotatably connecting the first housing and the second housing;
an elastic body 240 connected to the first housing;
a foot 250 connected to the elastic body, moving relatively away from the first housing by being pressed by the second housing while the second housing rotates in a first direction, and moving relatively closer to the first housing while the second housing rotates in a second direction opposite to the first direction.

2. The electronic device of claim 1, wherein the elastic body 240 is provided in an extended state, and the elastic body 240 brings the foot 250 into close contact with the second housing 220 by applying a restoring force to the foot 250.

3. The electronic device of claim 1 or 2, wherein the foot 250 comprises:
a foot frame 251 supporting the elastic body; and
a foot cover 252 covering the foot frame and having a material more flexible than a material of the foot frame.

4. The electronic device of any one of claims 1 to 3, further comprising:
a second hinge unit 260 comprising a first hinge frame 261 connected to the first housing and supporting one end of the elastic body and a second hinge frame 262 connected to the foot 250, supporting another end of the elastic body, and rotatably connected to the first hinge frame.

5. The electronic device of any one of claims 1 to 4, wherein the second hinge unit 260 further comprises:
a hinge shaft 263 having one end inserted into the first hinge frame and another end inserted into the second hinge frame and a central portion supporting the elastic body.

6. The electronic device of any one of claims 1 to 5, wherein the elastic body 240 is a torsion spring.

7. The electronic device of any one of claims 1 to 6, wherein one end 240a of the elastic body 240 is connected to the first hinge frame, and another end 240b of the elastic body 240 is connected to the second hinge frame.

8. The electronic device of any one of claims 1 to 7, wherein the one end 240a of the elastic body 240 is provided in a state pressed by the first housing and the first hinge frame, and the other end 240b of the elastic body 240 is provided in a state pressed by the second hinge frame and the foot.

9. The electronic device of any one of claims 1 to 8, wherein the first hinge frame 261 comprises:
a first frame body 2611 connected to the foot frame; and
a first frame arm 2612 extended from the first frame body and supporting one end of the shaft, and
the second hinge frame 262 comprises:
a second frame body 2621 connected to the first housing; and
a second frame arm 2622 extended from the second frame body and supporting another end of the shaft.

10. The electronic device of any one of claims 1 to 9, wherein the first housing comprises:
a positioning protrusion 213 inserted into an inside of the first hinge frame.

11. The electronic device of any one of claims 1 to 10, wherein the elastic body 340 is a plate spring.

12. The electronic device of any one of claims 1 to 11, further comprising:
a first screw 391 fixing one end of the elastic body 340 to the first housing; and
a second screw 392 fixing another end of the elastic body 340 to the foot.

13. The electronic device of any one of claims 1 to 12, further comprising:
a first damper 381 disposed at the second housing 320; and
a second damper 382 disposed at the foot 350 and facing the first damper.

14. The electronic device of any one of claims 1 to 13, wherein the first hinge unit comprises:
a hinge body;
a main shaft connected to the hinge body; and
a damper 225 protruding from the hinge body in a direction away from the main shaft and pressing the foot.

15. The electronic device of any one of claims 1 to 14, wherein the hinge body and the second housing are integrally formed.
